# EUROPÄISCHE PATENTSCHRIFT

(11) **EP 0 877 542 B1**
(45) Veröffentlichungstag und Bekanntmachung des Hinweises auf die Patenterteilung: **18.02.2004**
(21) Anmeldenummer: 98107236.6
(22) Anmeldetag: 21.04.1998
(51) Int. Cl.: H05K 7/14

(54) **Elektrisches oder elektronisches Gerät**
Electrical or electronic device
Appareil électrique ou électronique

(30) Priorität: 06.05.1997 DE 19718996
(43) Veröffentlichungstag der Anmeldung: 11.11.1998
(73) Patentinhaber: Phoenix Contact GmbH & Co. KG, 32825 Blomberg (DE)
(72) Erfinder: Feye-Hohmann, Jürgen, 32756 Detmold (DE)
(74) Vertreter: Gesthuysen, von Rohr & Eggert

(56) Entgegenhaltungen:
- EP-A- 0 039 175
- DE-A- 3 614 689
- FR-A- 2 559 335

## Beschreibung

Die Erfindung betrifft ein elektrisches oder elektronisches Gerät zum Aufsetzen auf eine Tragschiene, mit einem Gehäuse, mit wenigstens einer im Gehäuse angeordneten Leiterplatte und mit wenigstens einem Kontaktmittel einerseits zur Kontaktierung mit der Leiterplatte, andererseits für eine Daten- und/oder Energiebusverbindung mit benachbarten, auf die Tragschiene aufgesetzten und korrespondierende Kontaktmittel aufweisenden Geräten, wobei das Kontaktmittel einen Leiterplattenkontakt, einen vorderen Buskontakt und einen hinteren Buskontakt aufweist. Des weiteren betrifft die Erfindung ein Verfahren zur Herstellung eines Kontaktmittels für ein elektrisches oder elektronisches Gerät, insbesondere der vorgenannten Art, zum Aufsetzen auf eine Tragschiene, wobei das Gerät versehen ist mit einem Gehäuse, mit wenigstens einer im Gehäuse angeordneten Leiterplatte und mit wenigstens einem Kontaktmittel einerseits zur Kontaktierung mit der Leiterplatte, andererseits für eine Daten- und/oder Energiebusverbindung mit benachbarten, auf die Tragschiene aufgesetzten und korrespondierende Kontaktmittel aufweisenden Geräten, wobei das Kontaktmittel einen Leiterplattenkontakt, einen vorderen Buskontakt und einen hinteren Buskontakt aufweist.

Ein elektrisches oder elektronisches Gerät der eingangs genannten Art ist bereits aus der Praxis bekannt. Bei dem bekannten Gerät, das für die Daten- und/oder Energiebusverbindung eine Mehrzahl von Kontaktmitteln aufweist, besteht jedes einzelne Kontaktmittel aus einer Mehrzahl von Einzelteilen, die über eine Niet- oder Schweißverbindung elektrisch leitend miteinander verbunden sind. Die Herstellung des bekannten Kontaktmittels erfolgt derart, daß die einzelnen Kontaktstücke der Kontakte zunächst ausgestanzt und entsprechend gebogen werden, dann in die entsprechend erforderliche Anordnung zueinander gebracht und schließlich über die genannte Verbindung miteinander verbunden werden. Diese Art der Herstellung des bekannten Kontaktmittels ist mit relativ viel Aufwand verbunden.

Aufgabe der vorliegenden Erfindung ist es, ein Kontaktmittel für ein elektrisches oder elektronisches Gerät der eingangs genannten Art zur Verfügung zu stellen, das einfach und kostengünstig herstellbar ist.

Diese Aufgabe ist bei einem elektrischen oder elektronischen Gerät der zuvor genannten Art bzw. bei einem Verfahren zur Herstellung eines Kontaktmittels für ein Gerät der zuvor genannten Art dadurch gelöst, daß der Leiterplattenkontakt, der vordere Buskontakt und der hintere Buskontakt aus einem zusammenhängenden Stüok aus elektrisch leitendem Material hergestellt sind bzw. werden. Die Erfindung ermög-. licht es, durch einen einzigen Stanzvorgang und einige anschließende Biege- und ggf. weitere Bearbeitungsschritte das Kontaktmittel schnell und einfach herzustellen. Durch die Einteilig bzw. Einstückigkeit des Kontaktmittels entfällt die notwendige Verbindung der einzelnen Kontakte, was beim Stand der Technik erforderlich war.

Die konkrete Ausgestaltung der einzelnen Kontakte des Kontaktmittels sieht zweckmäßigerweise so aus, daß der Leiterplattenkontakt als tulpenartige Kontaktaufnahme mit zwei sich nach außen hin öffnenden Kontaktschenkeln ausgebildet ist, während die Leiterplatte etwa quer zur Tragschienenlängsrichtung angeordnet ist. Die vorgenannte Ausbildung des Leiterplattenkontaktes ermöglicht ein einfaches Einsetzen der Leiterplatte in das Gehäuse von oben her. Demgegenüber ist ein Buskontakt als Kontaktmesser, der andere Buskontakt als korrespondierende Kontaktaufnahme ausgebildet. Die Buskontakte selbst sind koaxial zur Tragschienenlängsrichtung im Gehäuse ausgerichtet. Dabei ist außerdem vorgesehen, daß die Kontaktaufnahme des Buskontaktes sich ausgehend von der Mittellängsachse nach außen zu ihren beiden Längsrändern hin öffnet, während das Kontaktmesser des Buskontaktes zu seinen beiden Längsrändern hin schmaler wird. Die Anschrägung bzw. Anfasung der beiden Längsränder des Kontaktmessers des einen Buskontaktes bzw. die sich öffnende Kontaktaufnahme des anderen Buskontaktes ermöglichen eine sichere Kontaktierung beim Aufschwenken eines elektrischen oder elektronischen Gerätes auf die Tragschiene mit benachbarten Geräten.

Bei einer bevorzugten Ausgestaltung der vorliegenden Erfindung sind die Buskontakte aus einem gefalteten ersten Streifen unter Bildung zweier Schenkel hergestellt. Dabei wird von dem einen, gefalteten Ende des Streifens das Kontaktmesser des einen Buskontaktes gebildet, während von dem anderen, offenen Ende die Kontaktaufnahme des anderen Buskontaktes gebildet wird. Der mit dem Buskontakt über einen Steg verbundene Leiterplattenkontakt steht dabei von einer Längsseite eines Schenkels des Streifens ab. Zur Gewährleistung einer guten Funktionsfähigkeit der Kontaktaufnahme des Buskontaktes ist an dem einen Schenkel des ersten Streifens eine Öffnung und an dem anderen Schenkel ein korrespondierender Vorsprung zum Eingreifen in die Öffnung vorgesehen. Im zusammengefalteten Zustand des ersten Streifens ist der Vorsprung form- und/oder reibschlüssig z. B. durch Anschlagen, Vernieten oder Verschweißen in der Öffnung gehalten.

Weitere Merkmale, Vorteile und Anwendungsmöglichkeiten der vorliegenden Erfindung ergeben sich aus der nachfolgenden Beschreibung von Ausführungsbeispielen anhand der Zeichnung und der Zeichnung selbst.

Es zeigt
- Fig. 1: eine perspektivische Ansicht eines erfindungsgemäßen elektronisches Gerätes in schematischer Darstellung,
- Fig. 2: eine perspektivische Ansicht eines Kontaktmittels eines erfindungsgemäßen Gerätes in einem Zwischenstadium der Fertigung,
- Fig. 3: eine perspektivische Ansicht des Kontaktmittels aus Fig. 2 in einem fortgeschrittenem Stadium der Fertigung und
- Fig. 4: eine perspektivische Ansicht des Kontaktmittels gemäß den Fig. 2 und 3 nach Fertigungsstellung.

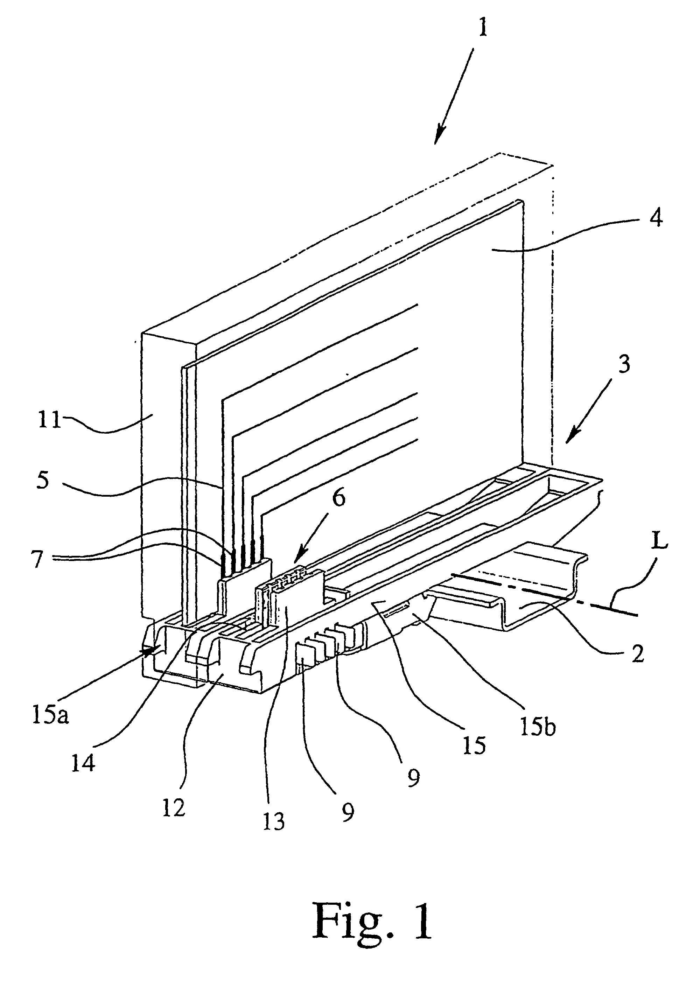

In Fig. 1 ist ein elektronisches Gerät 1 zum Aufsetzen auf eine Tragschiene 2 dargestellt. Bei der Tragschiene 2 handelt es sich vorliegend um eine Hutschiene. Das elektronische Gerät 1 selbst weist ein Gehäuse 3 auf, das aus einem isolierenden Material, insbesondere Kunststoff besteht. Im Gehäuse 3 befindet sich eine Leiterplatte 4. Die Leiterplatte 4 ist in an sich bekannter Weise mit Leiterbahnen 5 und mit nicht näher dargestellten elektronischen Bauteilen versehen.

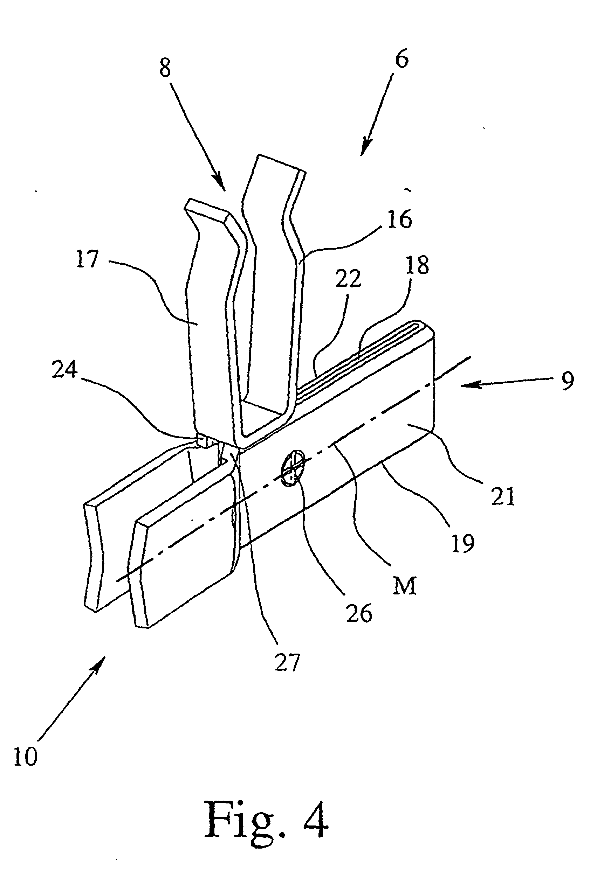

Des weiteren weist das Gerät 1 eine Mehrzahl von Kontaktmitteln 6 auf. Die Anzahl der Kontaktmittel 6 korrespondiert im vorliegenden Fall nach der Anzahl der Leiterbahnanschlüsse 7. Im in Fig. 1 dargestellten Ausführungsbeispiel sind fünf Kontaktmittel 6 vorgesehen. Die Kontaktmittel 6 dienen einerseits zur Kontaktierung mit der Leiterplatte 4, andererseits für eine Daten- und/oder Energiebusverbindung mit benachbarten, auf die Tragschiene 2 aufgesetzten und korrespondierende Kontaktmittel 6 aufweisenden Geräten 1. Wie sich insbesondere aus Fig. 4 ergibt, weist jedes der Kontaktmittel 6 einen Leiterplattenkontakt 8, einen vorderen Buskontakt 9 und ei-. nen hinteren Buskontakt 10 auf.

Elektronische Geräte 1 der zuvor beschriebenen Art können aufgrund ihrer Ausbildung auf der Tragschiene 2 aneinandergereiht werden, wobei sich über die jeweiligen Kontaktmittel 6 eine Daten- und/oder Energiebusverbindung ergibt.

Bei der in Fig. 1 dargestellten Ausführungsform ist es nun so, daß das Gehäuse 3 zweiteilig ausgebildet ist. Dies muß jedoch nicht so sein. Das Gehäuse 3 kann auch einteilig ausgebildet sein. Im dargestellten Ausführungsbeispiel weist das Gehäuse 3 ein die Leiterplatte 4 aufnehmendes Oberteil 11 und ein die Kontaktmittel 6 aufweisendes Sockelteil 12 auf. Zur Kontaktierung mit der Leiterplatte 4 weist das Sockelteil 12 eine Leiterplattenaufnahme 13 auf, die über die Oberseite 14 des Sockelteils 12 übersteht. In der Leiterplattenaufnahme 13 befinden sich die Leiterplattenkontakte 8 der einzelnen Kontaktmittel 6. Die vorderen Buskontakte 9 stehen im eingebauten Zustand über die eine Längsseite 15 des Sockelteils 12 über. Auf der gegenüberliegenden, nicht dargestellten Längsseite befinden sich die hinteren Buskontakte 10, was nicht dargestellt ist.

Zur lösbaren Verbindung des Oberteils 11 mit dem Sockelteil 12 dient eine Rastverbindung 15a. Zur lösbaren Verbindung des Sockelteils 12 mit der Tragschiene 2 dient eine lösbare Verriegelung, die beim Aufschwenken des Sockelteils 12 auf die Tragschiene 2 zum Tragen kommt. Zu diesem Zweck ist am Sockelteil 12 ein federbelasteter Riegel 15b vorgesehen, der zum einseitigen Untergreifen der Tragschiene 2 dient, wenn das Sockelteil 12 auf die Tragschiene 2 aufgeschwenkt wird.

Es ist nochmals darauf hinzuweisen, daß es sich bei der in Fig. 1 dargestellten Ausführungsform lediglich um ein erfindungsgemäßes Beispiel handelt. Insbesondere ist es nicht erforderlich, das Gehäuse 3 zweiteilig, also mit einem Oberteil 11 und einem Sockelteil 12 auszubilden.

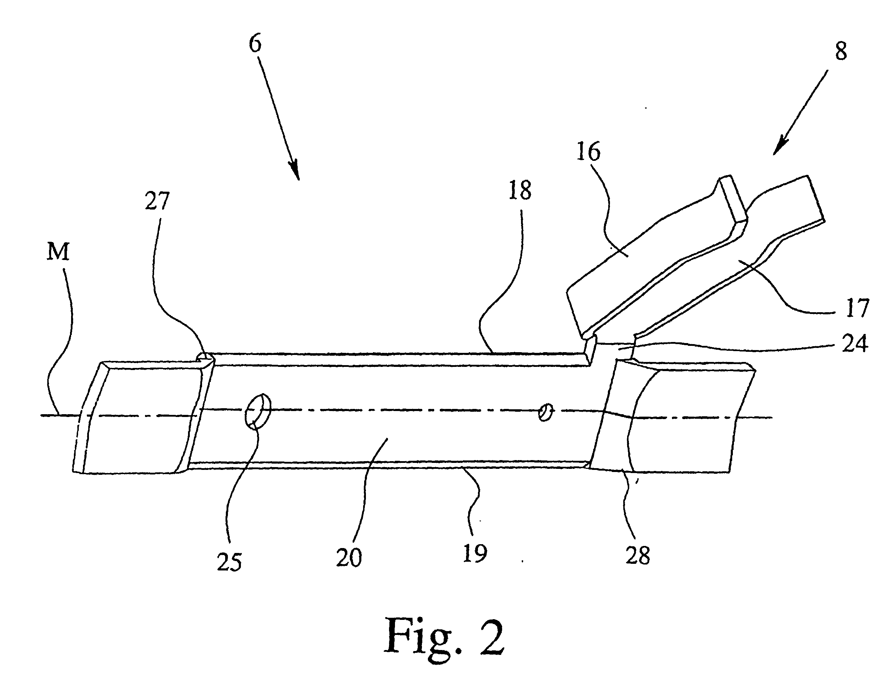

Wesentlich für die vorliegende Erfindung ist, daß der Leiterplattenkontakt 8, der vordere Buskontakt 9 und der hintere Buskontakt 10 aus einem zusammenhängenden Stück aus elektrisch leitendem Flachmaterial hergestellt sind. Dies ist insbesondere aus Fig. 2, in der ein Zwischenstadium der Fertigung dargestellt ist, gut erkennbar. Der Leiterplattenkontakt 8 ist im dargestellten Ausführungsbeispiel als sogenannte tulpenartige Kontaktaufnahme ausgebildet. Er weist hierzu zwei sich nach außen hin öffnende Kontaktschenkel 16, 17 auf. Insbesondere aus Fig. 1 ergibt sich, daß der Leiterplattenkontakt 8 derart ausgerichtet ist, daß die Leiterplatte 4 etwa quer zur Tragschienenlängsrichtung L angeordnet ist.

Wie sich weiter aus Fig. 4 ergibt, ist der vordere Buskontakt 9 als Kontaktmesser und der hintere Buskontakt 10 als Kontaktaufnahme ausgebildet. Die Buskontakte 9, 10 selbst sind koaxial zur Tragschienenlängsrichtung L im Gehäuse 3 bzw. Sockelteil 12 ausgerichtet. Damit der vordere Buskontakt 9 eines benachbarten elektronischen Gerätes 1 einfach in die Kontaktaufnahme des hinteren Buskontaktes 10 eingesetzt werden kann, erweitert sich diese ausgehend von der Mittellängsachse M nach außen hin. Demgegenüber wird das Kontaktmesser des vorderen Buskontaktes 9 zu seinen beiden Längsrändern 18, 19 hin schmaler. Auch dies erleichtert das Einführen bzw. Aufschwenken des elektronischen Gerätes 1 zur Herstellung der Daten- und/oder Energiebusverbindung mit benachbarten Geräten.

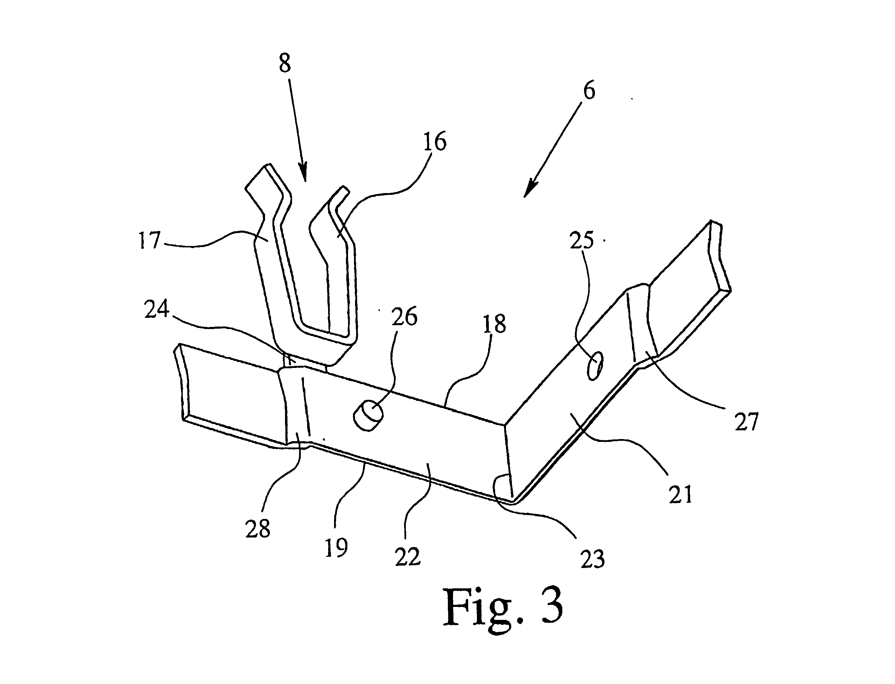

Wie sich insbesondere aus einer Zusammenschau der Fig. 2, 3 und 4 ergibt, sind die Buskontakte 9, 10 aus einem gefalteten ersten Streifen 20 (vgl. Fig. 2) unter Bildung zweier Schenkel 21, 22 hergestellt. Die beiden Schenkel 21, 22 werden über eine Falzlinie 23 voneinander getrennt. Dabei bildet das eine, gefaltete Ende des Streifens 20 das Kontaktmesser, d. h. den vorderen Buskontakt 9, während das andere, offene Ende des gefalteten Streifens 20 die Kontaktaufnahme des hinteren Buskontaktes 10 bildet. Der Leiterplattenkontakt 8 ist vorliegend an dem Längsrand 18 des Streifens 20 bzw. des Schenkels 22 vorgesehen. Die Verbindung mit dem Streifen 20 erfolgt dabei über einen Steg 24, der derart abgebogen ist, daß er über dem Schenkel 21 angeordnet ist.

Im in Fig. 4 dargestellten, zusammengefalteten Zustand sind die beiden Schenkel 21, 22 fest miteinander verbunden. Zu diesem Zweck befindet sich im Schenkel 21 eine Öffnung 25, während an dem anderen Schenkel 22 ein Vorsprung 26 vorgesehen ist. Der Vorsprung 26 kann einteilig mit dem Streifen 20 bzw. dem Schenkel 22 ausgebildet und beispielsweise durch Tiefziehen, Prägen oder Einstechen hergestellt sein. Es. kann sich hierbei aber auch um ein separates Teil, beispielsweise um einen Niet handeln. In diesem Falle ist auch im Schenkel 22 eine entsprechende Öffnung vorgesehen. Durch Vernieten, Anschlagen oder Verschweißen des Vorsprungs 26 ergibt sich eine form- und/oder reibschlüssige Verbindung in der Öffnung 25.

Die Herstellung des erfindungsgemäßen Kontaktmittels 6 läuft nun wie folgt ab. Aus einem Flachmaterial aus Metall wird ein zusammenhängendes Stück mit dem ersten Streifen 20 und einem parallel dazu verlaufenden zweiten Streifen, aus dem in einem späteren Fertigungsstadium der Leiterplattenkontakt 8 hergestellt wird, ausgestanzt, wobei die beiden Streifen über den Steg 24 miteinander verbunden sind. Beim Ausstanzen der beiden Streifen kann auch die Öffnung 25 gestanzt und der Vorsprung 26 vorgesehen werden. Sodann wird der erste Streifen 20 an seinen beiden Enden jeweils unter Bildung einer Stufe 27, 28 abgewinkelt. Die beiden abgewinkelten Enden, die später die Kontaktaufnahme des hinteren Buskontaktes 10 bilden, werden dann ausgehend von der Mittellängsachse M geringfügig abgewinkelt, so daß sich im gefalteten Zustand die zuvor beschriebene, sich nach außen erweiternde Öffnung des hinteren Buskontaktes 10 ergibt. Sodann kann der Streifen 20 mittig gefaltet werden, so daß an dem gefalteten Ende des ersten Streifens 20 das Kontaktmesser des vorderen Buskontaktes 9 und am hinteren Ende die Kontaktaufnahme des hinteren Buskontaktes 10 gebildet wird.

Außerdem wird der zweite Streifen zur Bildung des Leiterplattenkontaktes 8 derart geformt, daß sich die in den Fig. 2 bis 4 dargestellte "Tulpenform" mit den beiden sich nach außen hin erweiternden Kontaktschenkeln 16, 17 ergibt. Die Formung bzw. Biegung des Leiterplattenkontaktes 8 kann im übrigen auch erfolgen, bevor der Streifen 20 gefaltet wird. Außerdem ist es noch erforderlich, den zweiten Streifen bzw. den Leiterplattenkontakt 8 über den Steg 24 gegenüber dem ersten Streifen 20 abzuwinkeln und zwar etwa im rechten Winkel zur Ausrichtung des ersten Streifens 20.

Obwohl der Steg 24 am Übergang zur Stufe 28 vorgesehen ist, kann der Steg 24 auch anderer Stelle an einem der beiden Längsränder 18, 19 vorgesehen sein.

Der Streifen 20 wird zwischen den beiden Stufen 27, 28 an den Längsrändern 18, 19 jeweils angefast, so daß das Kontaktmesser des vorderen Buskontaktes 9 im zusammengefalteten Zustand (Fig. 4) an seinen beiden Längsrändern 18, 19 schmaler wird.

Nach dem vollständigen Zusammenfalten der beiden Schenkel 21, 22 wird der Vorsprung 26 in der Öffnung 25 angeschlagen, vernietet oder verschweißt, so daß sich eine form- und/oder reibschlüssige Verbindung zwischen den beiden Schenkels 21, 22 ergibt.

Soweit technisch möglich, ist die Reihenfolge der einzelnen Verfahrensschritte beliebig, was bedeutet, daß die zuvor genannten Verfahrensschritte, soweit technisch möglich, auch eine andere Reihenfolge als zuvor beschrieben haben können.

## Patentansprüche

1. Elektrisches oder elektronisches Gerät (1) zum Aufsetzen auf eine Tragschiene (2), mit einem Gehäuse (3), mit wenigstens einer im Gehäuse (3) angeordneten Leiterplatte (4) und mit wenigstens einem Kontaktmittel (6) einerseits zur Kontaktierung mit der Leiterplatte (4), andererseits für eine Daten- und/oder Energiebusverbindung mit benachbarten, auf die Tragschiene (2) aufgesetzten und korrespondierende Kontaktmittel (6) aufweisenden Geräten (1), wobei das Kontaktmittel (6) einen Leiterplattenkontakt (8), einen vorderen Buskontakt (9) und einen hinteren Buskontakt (10) aufweist, **dadurch gekennzeichnet, daß** der Leiterplattenkontakt (8), der vordere Buskontakt (9) und der hintere Buskontakt (10) aus einem zusammenhängenden Stück aus elektrisch leitendem Material hergestellt sind.

2. Elektrisches oder elektronisches Gerät nach Anspruch 1, **dadurch gekennzeichnet, daß** der Leiterplattenkontakt (8) als tulpenartige Kontaktaufnahme mit zwei sich nach außen hin erweiternden Kontaktschenkeln (16, 17) ausgebildet ist und daß, vorzugsweise, die Leiterplatte (4) etwa quer zur Tragschienenlängsrichtung (L) angeordnet ist.

3. Elektrisches oder elektronisches Gerät nach Anspruch 1 oder 2, **dadurch gekennzeichnet, daß** ein Buskontakt (9) als Kontaktmesser und der andere Buskontakt (10) als korrespondierende Kontaktaufnahme ausgebildet sind und daß, vorzugsweise, die Buskontakte (9, 10) koaxial zur Tragschienenlängsrichtung (L) ausgerichtet sind.

4. Elektrisches oder elektronisches Gerät nach Anspruch 3, **dadurch gekennzeichnet, daß** die Kontaktaufnahme des einen Buskontaktes (10) sich etwa ausgehend von der Mittellängsachse (M) nach außen hin erweitert.

5. Elektrisches oder elektronisches Gerät nach Anspruch 3 oder 4, **dadurch gekennzeichnet, daß** das Kontaktmesser des anderen Buskontaktes (9) zu seinen beiden Längsrändern (18, 19) hin schmaler wird.

6. Elektrisches oder elektronisches Gerät nach einem der Ansprüche 1 bis 5, **dadurch gekennzeichnet, daß** die Buskontakte (9, 10) aus einem gefalteten ersten Streifen (20) des Stückes unter Bildung zweier Schenkel (21, 22) hergestellt sind, wobei an dem einen, gefalteten Ende des Streifens (20) das Kontaktmesser und an dem anderen Ende die Kontaktaufnahme vorgesehen sind und daß von einem Längsrand (18) eines. Schenkels (22) der Leiterplattenkontakt (8) absteht.

7. Elektrisches oder elektronisches Gerät nach Anspruch 6, **dadurch gekennzeichnet, daß** an dem einen Schenkel (21) eine Öffnung (25) und an dem anderen Schenkel (22) ein korrespondierender Vorsprung (26) zum Eingreifen in die Öffnung (25) vorgesehen ist und daß, vorzugsweise, der Vorsprung (26) form- und/oder reibschlüssig in der Öffnung (25) gehalten ist.

8. Verfahren zur Herstellung eines Kontaktmittels (6) für ein elektrisches oder elektronisches Gerät (1), insbesondere nach einem der Ansprüche 1 bis 7, zum Aufsetzen auf eine Tragschiene (2), wobei das Gerät (1) versehen ist mit einem Gehäuse (3), mit wenigstens einer im Gehäuse (3) angeordneten Leiterplatte (4) und mit wenigstens einem Kontaktmittel (6) einerseits zur Kontaktierung mit der Leiterplatte (4), andererseits für eine Daten- und/oder Energiebusverbindung mit benachbarten, auf die Tragschiene (2) aufgesetzten und korrespondierende Kontaktmittel (6) aufweisenden Geräten (1), wobei das Kontaktmittel (6) einen Leiterplattenkontakt (8), einen vorderen Buskontakt (9) und einen hinteren Buskontakt (10) aufweist, **dadurch gekennzeichnet, daß** der Leiterplattenkontakt (8), der vordere Buskontakt (9) und der hintere Buskontakt (10) aus einem zusammenhängenden Stück aus elektrisch leitendem Material hergestellt werden.

9. Verfahren nach Anspruch 8, **dadurch gekennzeichnet, daß** aus dem Stück ein erster Streifen (20) und ein damit über einen Steg (24) verbundener etwa parallel dazu verlaufender zweiter Streifen ausgestanzt werden, daß der erste Streifen (20) an seinen beiden Enden jeweils unter Bildung einer Stufe (27, 28) abgewinkelt und unter Bildung zweier Schenkel (21, 22) mittig gefaltet wird, so daß sich an dem gefalteten Ende des ersten Streifens (20) ein Kontaktmesser eines Buskontaktes (9) und an dem anderen Ende eine Kontaktaufnahme eines Buskontaktes (10) ergeben, daß der zweite Streifen zur Bildung der Leiterplattenkontaktes (8) als tulpenartige Kontaktaufnahme mit zwei sich nach außen hin erweiternden Kontaktschenkeln (16, 17) gebogen wird und daß der zweite Streifen über den Steg (24) etwa im rechten Winkel zum ersten Streifen (20) abgewinkelt wird.

10. Verfahren nach Anspruch 9, **dadurch gekennzeichnet, daß** der erste Streifen (20) an seinen beiden Enden ausgehend von der Mittellängsachse (M) abgewinkelt wird, so daß sich die Kontaktaufnahme des Buskontaktes (10) im zusammengefalteten Zustand des ersten Streifens (20) nach außen zu ihren beiden Längsrändern (18, 19) hin öffnet.

11. Verfahren nach Anspruch 9 oder 10, **dadurch gekennzeichnet, daß** der erste Streifen (20) in seinem mittigen Bereich an seinem oberen und seinem unteren Längsrand (18, 19) angefast ist, so daß das Kontaktmesser des Buskontaktes (9) im zusammengefalteten Zustand des ersten Streifens (20) an seinen beiden Längsrändern (18, 19) schmaler wird.

12. Verfahren nach einem der Ansprüche 9 bis 11, **dadurch gekennzeichnet, daß** in den einen Schenkel (21) des ersten Streifens (20) eine Öffnung (25) eingebracht und an dem anderen Schenkel (22) ein korrespondierender Vorsprung (26) zum Eingreifen in die Öffnung (25) vorgesehen wird, und daß, vorzugsweise, der Vorsprung (26) nach dem Falten des ersten Streifens (20) zur Erzielung einer form- und/oder reibschlüssigen Verbindung in der Öffnung (25) angeschlagen, angenietet oder angeschweißt wird.

## Claims

1. Electrical or electronic device (1) for seating on a mounting rail (2) comprising a housing (3) with at least one circuit board (4) located in housing (3) and with at least one contact means (6) on the one hand, for making contact with the circuit board (4), and on the other hand, for providing a data and/or power bus connection with adjacent devices (1) having corresponding contact means (6) and being seated on the mounting rail (2), wherein the contact means (6) has a circuit board contact (8) a front bus contact (9) and an rear bus contact (10), **characterized in that** the circuit board contact (8), the front bus contact (9) and the rear bus contact (10) are formed as part of the same continuous piece of electrically conductive material.

2. Electrical or electronic device according to claim 1, **characterized in that** the circuit board contact (8) has a tulip-shaped contact receiver with two contact legs (16, 17) which flare outwardly and that the circuit board (4) is located roughly transversely to a longitudinal direction (L) of the mounting rail.

3. Electrical or electronic device according to claim 1 or 2, **characterized in that** a bus contact (9) is a contact blade and a second bus contact (10) is a contact receiver and that, preferably, the bus contacts (9, 10) are aligned coaxially to said longitudinal direction (L) of said mounting rail.

4. Electrical or electronic device according to claim 3, **characterized in that** the contact receiver of the bus contact (10) flares outwardly from a central longitudinal axis (M).

5. Electrical or electronic device according to claim 3 or 4, **characterized in that** the contact blade of the front bus contact (9) becomes narrower toward its two longitudinal edges (18, 19).

6. Electrical or electronic device according to any one of claims 1 to 5, **characterized in that** the bus contacts (9, 10) are formed of a folded first strip (20) of a piece forming a pair of legs (21, 22), wherein the contact blade is provided on one folded end of the strip (20) and the contact receiver on the other end and that the circuit board contact (8) projects from a longitudinal edge (18) of one of the legs(22).

7. Electrical or electronic device according to claim 6, **characterized in that** an opening (25) is provided on one of said legs (21) and a corresponding projection (26) for fitting into said opening (25) is provided on the other of said legs (22) and that, preferably, said projection (26) is held in said opening (26) by one of a form-fit and a force-fit connection.

8. Process for producing a contact means (6) for an electrical or electronic device (1), in particular according to any one of claims 1 to 7, for seating on a mounting rail (2) wherein the device (1) is provided with a housing (3) with at least one circuit board (4) located in the housing (3) and with at least one contact means (6) on the one hand, for making contact with the circuit board (4), and on the other hand, for providing a data and/or power bus connection with adjacent devices (1) having corresponding contact means (6) and being seated on the mounting rail (2) wherein the contact means (6) has a circuit board contact (8), a front bus contact (9) and a rear bus contact (10), **characterized in that** the circuit board contact (8), the front bus contact (9) and the rear bus contact (10) are produced of one continuous piece of electrically conductive material.

9. Process as claimed in claim 8, **characterized in that** a first strip (20) is punched out of the piece and therewith a second strip joined via a bridge (24) running roughly parallel thereto, that the first strip (20) is angled on both ends forming a step (27, 28) and is folded in the middle to form two legs (21, 22) so that a contact blade of a bus contact (9) on the folded end of the first strip (20) and a contact receiver of a bus contact (10) on the other end result, that the second strip for forming the circuit board contact (8) is bent into the form of a tulip-shaped contact receiver having two contact legs (16, 17) flaring outward and that the second strip is angled via said bridge (24) roughly at a right angle to said first strip(20).

10. Process according to claim 9, **characterized in that** said first strip (20) is angled on ends proceeding from a central longitudinal axis (M) thereof so that in the folded state of the first strip (20), the contact receiver of the bus contact (10) flares outwardly toward longitudinally extending edges (18, 19) thereof.

11. Process according to claim 9 or 10, **characterized in that** the first strip (20) in a central area is beveled on upper and lower longitudinally extending edges (18, 19) thereof, so that in the folded state of the first strip (20), the contact blade of bus contact (9) narrows at said longitudinally extending edges (18, 19).

12. Process according to any one of claims 9 to 11, **characterized in that** an opening (25) is provided in one leg (21) of the first strip (20) and a corresponding projection (26) for fitting into said opening (25) is provided on the other leg and that, preferably, the projection (26) is secured, riveted or welded in said opening (25) when said first strip (20) is folded for the purposes of a form-fit and/or force-fit connection.

## Revendications

1. Appareil électrique ou électronique (1) à poser sur un rail porteur (2), comportant un boîtier (3), comprenant au moins une plaquette de circuit imprimé (4) disposée dans le boîtier (3) et au moins un moyen de contact (6) d'une part pour la mise en contact avec la plaquette de circuit imprimé (4), d'autre part pour une liaison à bus d'énergie et/ou de données avec des appareils (1) voisins posés sur le rail porteur (2) et présentant des moyens de contact correspondants (6), le moyen de contact (6) présentant un contact de plaquette de circuit imprimé (8), un contact de bus avant (9) et un contact de bus arrière (10),
**caractérisé en ce que**
le contact de plaquette de circuit imprimé (8), le contact de bus avant (9) et le contact de bus arrière (10) sont fabriqués dans une pièce continue de matériau conducteur d'électricité.

2. Appareil électrique ou électronique selon la revendication 1, **caractérisé en ce que** le contact de plaquette de circuit imprimé (8) est conçu comme un récepteur de contact en tulipe comportant deux branches de contact (16, 17) s'élargissant vers l'extérieur et que la plaquette de circuit imprimé (4) est disposée de préférence un peu transversalement par rapport au sens longitudinal du rail porteur (L).

3. Appareil électrique ou électronique selon la revendication 1 ou 2, **caractérisé en ce qu'**un contact de bus (9) est conçu comme une lame de contact et l'autre contact de bus (10) comme un récepteur de contact correspondant et que les contacts de bus (9, 10) sont de préférence orientés coaxialement par rapport au sens longitudinal du rail porteur (L).

4. Appareil électrique ou électronique selon la revendication 3, **caractérisé en ce que** le récepteur de contact de l'un des contacts de bus (10) s'élargit un peu en partant de l'axe longitudinal médian (M) vers l'extérieur.

5. Appareil électrique ou électronique selon la revendication 3 ou 4, **caractérisé en ce que** la lame de contact de l'autre contact de bus (9) devient plus étroite vers ses deux bords longitudinaux (18, 19).

6. Appareil électrique ou électronique selon l'une quelconque des revendications 1 à 5, **caractérisé en ce que** les contacts de bus (9, 10) sont réalisés à partir d'une première bande pliée (20) de la pièce en formant deux branches (21, 22), la lame de contact étant prévue à une extrémité pliée de la bande (20) et le récepteur de contact à l'autre extrémité, et que le contact de plaquette de circuit imprimé (8) dépasse d'un bord longitudinal (18) d'une branche (22).

7. Appareil électrique ou électronique selon la revendication 6, **caractérisé en ce que**, sur une branche (21), une ouverture (25) et, sur l'autre branche (22), une saillie correspondante (26) s'engrenant dans l'ouverture (25) sont prévues et que la saillie (26) est maintenue de préférence en liaison de forme et/ou de frottement dans l'ouverture (25).

8. Procédé de fabrication d'un moyen de contact (6) pour un appareil électrique ou électronique (1), notamment selon l'une quelconque des revendications 1 à 7, à poser sur un rail porteur (2), l'appareil (1) étant pourvu d'un boîtier (3), comportant au moins une plaquette de circuit imprimé (4) disposée dans le boîtier (3) et au moins un moyen de contact (6) d'une part pour la mise en contact avec la plaquette de circuit imprimé (4), d'autre part pour une liaison de bus de données et/ou d'énergie avec des appareils (1) voisins posés sur le rail porteur (2) et présentant des moyens de contact correspondants (6), le moyen de contact (6) présentant un contact de plaquette de circuit imprimé (8), un contact de bus avant (9) et un contact de bus arrière (10),
**caractérisé en ce que**
le contact de plaquette de circuit imprimé (8), le contact de bus avant (9) et le contact de bus arrière (10) sont fabriqués à partir d'une pièce continue de matériau conducteur d'électricité.

9. Procédé selon la revendication 8, **caractérisé en ce qu'**on découpe dans la pièce une première bande (20) et une deuxième bande reliée à celle-ci par une traverse (24) et s'étendant approximativement parallèlement à celle-ci, que la première bande (20) est coudée à ses deux extrémités respectivement en formant un étage (27, 28) et est pliée au milieu en formant deux branches (21, 22), de sorte qu'on obtient à l'extrémité pliée de la première bande (20) une lame de contact d'un contact de bus (9) et à l'autre extrémité un récepteur de contact d'un contact de bus (10), que la deuxième bande servant à former le contact de plaquette de circuit imprimé (8) sous forme d'un récepteur de contact en tulipe avec deux branches de contact (16, 17) s'élargissant vers l'extérieur est cintrée et que la deuxième bande est coudée au dessus de la traverse (24) approximativement à angle droit par rapport à la première bande (20).

10. Procédé selon la revendication 9, **caractérisé en ce que** la première bande (20) est coudée à ses deux extrémités en partant de l'axe longitudinal médian (M), de sorte que le récepteur de contact du contact de bus (10) s'ouvre, en position repliée de la première bande (20), vers l'extérieur en direction de ses deux bords longitudinaux (18, 19).

11. Procédé selon la revendication 9 ou 10, **caractérisé en ce que** la première bande (20) est chanfreinée dans sa zone centrale sur son bord longitudinal supérieur et inférieur (18, 19), de sorte que la lame de contact du contact de bus (9) devient plus étroite, en position repliée de la première bande (20), sur ses deux bords longitudinaux (18, 19).

12. Procédé selon l'une quelconque des revendications 9 à 11, **caractérisé en ce que**, dans une branche (21) de la première bande (20), une ouverture (25) est pratiquée et que sur l'autre branche (22), une saillie correspondante (26) est prévue pour s'engrener dans l'ouverture (25), et que la saillie (26) est de préférence calée, rivetée ou soudée après le pliage de la première bande (20) pour obtenir une liaison de forme et/ou de frottement dans l'ouverture (25).
